# EUROPEAN PATENT SPECIFICATION

(11) **EP 0 560 310 B1**
(45) Date of publication and mention of the grant of the patent: **10.06.1998**
(21) Application number: 93103807.9
(22) Date of filing: 10.03.1993
(51) Int. Cl.: G03H 1/26, G03F 7/20, G03H 1/00

(54) **Method for the manufacture of high-quality total internal reflection holograms**
Verfahren zum Herstellen von inneren Totalreflexionshologrammen hoher Qualität
Méthode pour la production d'hologrammes à réflexion interne totale de haute qualité

(30) Priority: 13.03.1992 GB 9205560
(43) Date of publication of application: 15.09.1993
(73) Proprietor: HOLTRONIC TECHNOLOGIES LTD., London EC4A 1NH (GB)
(72) Inventor: Clube, Francis Stace Murray, CH-2000 Neuchâtel (CH)
(74) Representative: Hasler, Erich, Dr.

(56) References cited:
- EP-A- 0 251 681
- WO-A-91/17488
- US-A- 3 591 252
- US-A- 3 601 465
- PROCEEDINGS OF THE SPIE : OPTICAL/LASER MICROLITHOGRAPHY V, vol.1674, no.2, March 1992, BELLINGHAM, US pages 783 - 792 FRANCIS CLUBE ET AL. 'HOLOGRAPHIC MASK-ALIGNER'
- SOLID STATE TECHNOLOGY, vol.34, no.9, September 1991, WASHINGTON US pages 89 - 93 BASIL A. OMAR ET AL. 'ADVANCES IN HOLOGRAPHIC LITHOGRAPHY'
- OPTICS LETTERS, vol.15, no.15, 1 August 1990, WASHINGTON US pages 869 - 871 RAY T. CHEN ET AL. 'SUBMICROMETER LITHOGRAPHY USING LENSLESS HIGH-EFFICIENCY HOLOGRAPHIC SYSTEMS'

## Description

The present invention relates generally to the field of microlithography as employed for the manufacture of electronic and other types of device comprising high-resolution features. It takes advantage of the particular imaging properties of total internal reflection holography to achieve a novel method and apparatus for attaining greater lithographic accuracy and therefore superior device performance.

Most high-resolution (<1.5µm) lithographic processes for fabricating microdevices start with a mask, or a set of masks, defining the pattern of features that need to be formed on a substrate surface, for instance, on a silicon wafer. The pattern is transferred to the substrate either by contact printing the mask or by imaging the mask through a lens and/or mirror system. The latter is often preferable, especially for large production quantities, because it avoids damage to the mask. The main shortcoming of high-resolution imaging systems (apart from their cost) is that off-axis optical aberrations limit the size of the exposure field to typically 1.5 x 1.5cm², and in order to print onto a larger area, such as an 8" diameter silicon wafer, a multi-exposure step-and-repeat procedure is employed, in which each exposure prints a single device, or maybe a small number of devices, and the wafer is translated between exposures. Not only is this size of exposure field restrictive for many types of device (eg. for CCDs and DRAMs) but the stepping motion requires very sophisticated mechanics in order to achieve good layer-to-layer registration and high throughput.

Device performance is dependent on how accurately the smallest device features (critical dimensions or CDs) can be realised and located with respect to other features. For this reason the pattern in the mask is best fabricated using electron beam (e-beam) lithography. However, although very precise, e-beam lithography also has its limitations. An approach that is therefore commonly used to ensure high accuracy of printed features is to fabricate the mask at a scale five times larger than the pattern required and then, during pattern transfer, to image the mask through 5x reduction optics. By this way any CD or placement errors present in the mask are demagnified to acceptable levels. The problem with this approach is that the reduction optics introduce their own aberrational errors: lens distortion, astigmatism and coma, and these degrade the feature placement accuracy and the CD control.

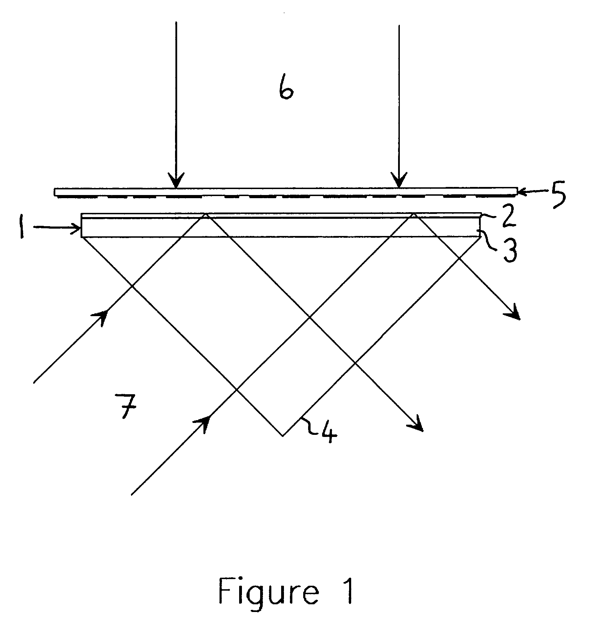

Total internal reflection (TIR) holography has been demonstrated to be powerful technique for sub-micron lithography [**1-3**]. The main principles of TIR hologram recording are illustrated in Figure **1**. A holographic plate **1** comprising a holographic recording layer **2** on a substrate **3** is in optical contact with a surface of a large prism **4**. An object in the form of a mask transparency **5** lies in proximity to the recording layer **2**. Two mutually coherent beams illuminate the system. One, the object beam **6**, passes through the mask transparency **5** to the recording layer **2** and the other, the reference beam **7**, is directed through another face of the prism **4** so that it is totally reflected from the surface of the holographic layer **2**. The optical interference of the two beams **6 and 7** is recorded by the photosensitive material in the layer **2** to produce a TIR hologram. The hologram is reconstructed by irradiating it with a laser beam directed in the opposite direction to the reference beam **7**. This generates an accurate reproduction of the pattern contained in the original mask **5**, and this can be used to perform lithography. TIR holographic imaging, unlike imaging through lens or mirror systems, is free of off-axis aberrations and so allows near diffraction-limited resolution which is furthermore independent of field size. It is therefore able from a single reconstruction to print high-resolution features over very large exposure fields.

However, TIR holography does not permit demagnification of the mask pattern : it is intrinsically a 1x process. Therefore any errors contained in the e-beam mask will necessarily be recorded in the TIR hologram and exactly transferred into the device. With respect to the origins of e-beam mask errors, the placement errors are caused predominantly by mechanical instabilities in the e-beam lithographic system, which are less controllable the longer the write time; whilst the CD errors are introduced predominantly by the spin processing applied to the mask substrate, and these errors vary slowly over the mask area. Therefore, by limiting the mask pattern to a small area (eg. ∼2 x 2cm²) mask errors can be kept to a low level. A small mask pattern has the additional significant advantages of appreciably reducing the mask cost, particulary if the features are very small (eg. < 0.5µm), and also allows redundancy to be used to eliminate mask defects, that is, by writing a number of patterns onto the mask, one can be assured of at least one pattern that will be defect-free. Unfortunately employing such a mask in the TIR hologram recording method as described in the prior art severely compromises the unlimited field capability of TIR holograms. Such a small hologram could be used in a step-and-repeat printing system but such a strategy, as explained above, is not usually desirable.

WO 91/17488 relates to a method for use in the manufacture of a transistor or other integrated circuit by internal total reflection holography. In one embodiment of the invention it is proposed to alter the distance between the mask and the recording medium for each successive exposure. In this way several images can be stacked in respective planes of the recording medium. This technique serves for extending the image contrast of the mask pattern along the light axis.

It is therefore an object of the present invention to provide a method of manufacturing TIR holograms that permits high-resolution, high-accuracy and defect-free patterns to be full-field printed (ie. in a single exposure, without recourse to stepping) over large-area substrates. The invention is an apparatus for and a technique of constructing a plurality of high-quality sub-holograms over a large substrate. The array TIR hologram thus formed can be used to full-field print devices onto large substrates.

According to the present invention there is provided a method and an apparatus for manufacturing an array TIR hologram for printing a pattern of high-quality microfeatures over a large area as defined in claims 1 and 10, respectively.

Said large area preferably corresponds to the complete area to be printed, although it may also refer to a substantial part of that area (eg. half) in which case, during printing, a small number of step-and-repeat operations (eg. two) are required to print the complete area.

Preferred embodiments of the various aspects of the present invention will now be described in detail with reference to the accompanying drawings.

Figure **1**, already described, shows the main principles of total internal reflection holography.

Figure **2** shows schematically a system for manufacturing high-quality total internal reflection holograms for large-field printing, in accordance with the invention.

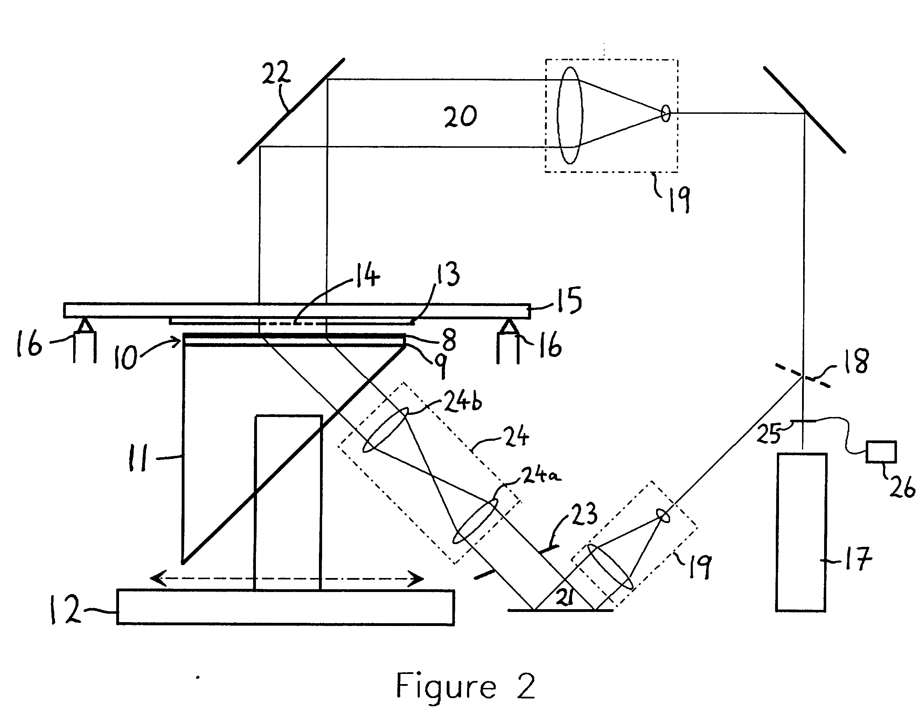

With reference to Figure **2**, a holographic recording layer **8**, approximately 15 micron thick, is laminated, or spun, onto a large 5'' diameter glass substrate **9**. A holographic recording medium that is particularly good for precision imaging is manufactured by Du Pont de Nemours & Co and identified as HRF-352. This material is a monomer that polymerises on exposure to light, the hologram being recorded as a spatial modulation of refractive index. Since it is desirable to use short wavelengths, specifically ultraviolet (UV), for micro-imaging, the supporting substrate **9** should be transparent to the UV. Fused silica is an optically desirable material and readily available.

The holographic plate **10**, comprising the holographic recording layer **8** and the substrate **9**, is placed in optical contact with a prism **11** by way of a layer of index matching fluid therebetween. A suitable fluid is the hydrocarbon xylene. The holographic plate **10** and the prism **11** remain in intimate contact throughout the recording process : whenever the prism **11** is moved, the holographic **10** plate moves with it.

The prism **11** is mounted to a high accuracy translation stage **12**. The stage **12** is able to travel in two orthogonal directions, permitting motion of the holographic layer **8** in the plane of the layer. For the manufacture of micro devices comprising many layers of features and consequently requiring accurate registration between layers, it is further preferable that the stage **12** be equiped with laser interferometers so that the holographic layer **8** can be translated with high precision.

An e-beam written mask **13** defining a pattern of features **14** of resolution 0.5µm in a pattern area 2cm x 2cm is procured. The placement accuracy of features in the pattern **14** is ±0.05µm and the spread of CD errors is ±0.03µm. The area on the mask **13** surrounding the pattern **14** is opaque, for reasons explained later.

The mask **13** is mounted to a vacuum chuck **15** and the chuck **15** is placed on piezoelectric transducers **16** so that the mask **13** lies in close proximity to the recording layer **8**.

The mask **13** is then accurately positioned using the piezo-electric transducers **16** so that it lies parallel and at a distance of 100µm from the recording layer **8**.

The measurement of the separation of the mask **13** and holographic layer **8** and determination of their parallelism are preferably carried out interferometrically using laser beams introduced through the vertical face of the prism (for instance using the technique described in EP-A-0421645). The apparatus for doing this is not shown in the figure as it could be easily formulated by a skilled person.

An argon ion laser **17** operating at a wavelength of 364nm, a beam splitter **18** and beam expanding optics **19** are used to generate two mutually coherent, collimated and large diameter beams: an object beam **20** and a reference beam **21**. The object beam **20** is directed by a mirror **22** to the mask **13** such that it illuminates it at normal incidence, and the reference beam **21** passes through the hypotenuse face of the prism **11** and illuminates the recording layer **8** at such an angle that it is totally internally reflected from the layer surface.

Before arriving at the prism **11** the reference beam **21** passes through an aperture **23** and an optical relay **24**, comprising two lenses **24a** and **24b**. The function of the optical relay is to image the illuminated aperture **23** onto the recording layer **8**. The aperture **23** is positioned at the front focal plane of lens **24a**, and the second lens **24b** is placed such that its front focal plane is co-planar with the back focal plane of the lens **23a**. The back focal plane of lens **24b** is at the recording layer **8**. In order that the image of the aperture **23** lies in the plane of the recording layer, the aperture **23** is appropriately oriented at the front focal plane of lens **24a**.

The purpose of the aperture **23** and optical relay **24** is to ensure that only that part of the holographic layer **8** immediately below the pattern **14** in the mask **13** is illuminated by the reference beam **21** and furthermore to ensure that this beam **21** is uniformly bright and well-collimated across its extent. The opaque area surrounding the pattern **14** in the mask **13** shields the rest of the holographic layer **8** from the object beam **20**. By these means the separation of sub-holograms can be minimised while ensuring good uniformity of image brightness and no interference between sub-holograms.

Exposure of the recording layer **8** to the illuminating object and reference beams **20** and **21** results in a sub-hologram of the pattern **14** in the mask **13** being recorded in that part of the layer **8** directly below the pattern in the mask **13**. After sufficient exposure with regard to the sensitivity of the material, the beam from the laser **17** is interrupted by a mechanical shutter **25** controlled by a timing mechanism **26**.

The prism **11** and holographic plate **10** are then translated laterally using the translation stage **12** by a distance such that the exposed part of the recording layer **8** is moved away from the region of intersection of the two beams **20** and **21** and an unexposed region of the layer **8** is moved in. As mentioned earlier, for multi-level devices this movement must be carried out with precision in order that accurate overlay can be achieved during lithography.

Following this, it may be necessary to readjust the piezo -electric transducers **16** supporting the mask **13** in order that the mask **13** remains parallel to the recording layer **8** and at the same distance from the layer **8**.

In the case where the direction of translation of the recording layer **8** lies in the plane of incidence of the reference beam **21** at the layer **8**, the aperture **23** should ideally be shifted longitudinally, that is, along the optical axis of the relay lens system **24**, in order that the image of the aperture remains accurately focussed onto the recording layer **8**.

The translation of the recording layer **8** with respect to the mask **13** may alternatively be achieved by a displacement of the mask **13**. However, in this case, the object and reference beams **20 and 21** must preferably be displaced as well in order to ensure good reproducibility of exposure energy from exposure to exposure. The mechanical arrangement required for implementing this, which is not shown in Figure **2**, is more elaborate, making this approach less desirable.

The mechanical shutter **25** is activated again and the fresh part of the holographic layer **8** now under the pattern in the mask is exposed for the same length of time to the object and reference beams **20** and **21**, to form another sub-hologram.

In case the output of the laser is not sufficiently stable to ensure equality of exposure for each sub-hologram so as to obtain equal sub-hologram efficiencies, the mechanical shutter **25** may alternatively be controlled from a light integrator that measures the total exposure energy.

These step-and-expose operations are subsequently repeated many times to construct an array of sub-holograms whose total area corresponds to that of the substrate to be printed.

The holographic plate **10** is then removed from the prism **11** and the holographic layer **8** is fixed by exposing it to an incoherent light source such as a mercury lamp. An alternative fixing procedure is to include this operation as part of the repeat sequence, that is, to fix each sub-hologram immediately following holographic exposure and before translating the prism assembly for exposure of the next sub-hologram. This would best be done *in situ* by way of another optical sub-system.

The resulting array TIR hologram can then be inserted into a TIR holographic lithographic system in order that the high-quality images from all the sub-holograms can be printed in one exposure onto a large substrate.

### References

1. R.Dändliker, J.Brook, "Holographic Photolithography for Submicron VLSI Structures", IEEE Conf. Proc.Holographic Systems, Components and Applications, Bath, U.K., p.311 (1989).
2. S.Gray, M.Hamidi, "Holographic Microlithography for Flat Panel Displays", SID 91 Digest pp.854-857 (1991).
3. B.A.Omar, F.Clube, M.Hamidi, D.Struchen, S.Gray, "Advances in Holographic Lithography", Solid State Technology, pp.89-93, Sept.1991.

## Claims

1. A method for manufacturing a total internal reflection (TIR) hologram array for printing a pattern of high-quality microfeatures over a large area, which method includes:
a) providing a substrate (9) having the size of the complete pattern, to be printed said substrate bearing a holographic recording medium (8);
b) providing a mask (13) defining a part of the pattern to be printed;
c) recording in the holographic recording medium (8) a TIR sub-hologram of the part of the pattern defined by the mask;
d) moving said holographic recording medium (8) or said mask (13) with respect to each other in a direction substantially parallel to the holographic recording medium (8), so as to present a new part of the holographic recording medium for recordal therein of another TIR sub-hologram of the or another mask; and
e) further comprising the step of repeating steps c) and d) as many times as necessary so as to record in the holographic recording medium an array of TIR sub-holograms recording the pattern to be printed.

2. A method according to claim 1 wherein recording a TIR sub-hologram in the holographic recording medium comprises the steps of
- optically contacting the substrate to a first face of a prism;
- generating two mutually coherent and collimated beams, namely an object beam and a reference beam;
- directing the object beam (20) to the mask (13) so that it illuminates it at normal incidence;
- directing the reference beam through a second prism face so that it illuminates the recording layer (8) at such an angle that it is totally internally reflected from the layer.

3. A method according to claim 1 or 2 wherein in step (d) said movement is effected in one or more of two orthogonal directions.

4. A method according to any one of claims 1 to 3 wherein the mask is held substantially parallel to the holographic recording medium and at a fixed distance therefrom.

5. A method according to any one of claims 1 to 4 wherein the distance between the mask (13) and the layer (8) is measured and readjusted after recording and moving in an unexposed region of the layer (8).

6. A method according to any one of claims 1 to 5 further comprising the step of fixing each sub-hologram immediately after its recording in the holographic recording medium.

7. A method according to any one of claims 1 to 6 further comprising the step of fixing the array of TIR sub-holograms subsequent to their recording in the holographic recording medium.

8. A method according to any one of claims 2 to 7 wherein the reference beam passes through an aperture (23) and an optical relay (24) in order to image the illuminated aperture (23) onto the recording layer (8).

9. A method according to any one of claims 1 to 8, further comprising the step of printing the large area or a substantial part of that area in a small number of step-and-repeat operations onto a large substrate.

10. An apparatus for manufacturing a total internal reflection (TIR) hologram array for full-field printing of a pattern of microfeatures with high accuracy over a large area, which apparatus includes:
a) a substrate (9) having at least the size of the complete pattern to be printed, said substrate bearing a holographic recording medium (8);
b) a mask (13) defining a part of the pattern to be printed;
c) means for recording in the holographic recording medium (8) a TIR sub-hologram of the part of the pattern defined by the mask (13);and
d) means for moving (12) said holographic recording medium (8) or said mask (13) with respect to each other in a plane substantially parallel to the holographic recording medium (8), for presenting a new part of the holographic recording medium (8) for recording therein of another TIR sub-hologram of the or another mask (13).

11. An apparatus according to claim 9 wherein the area surrounding the mask pattern is opaque and the reference beam passes through an aperture (23) and an optical relay (24) in order to image the illuminated aperture (23) onto the recording layer (8).

12. An apparatus according to claim 9 or 10, further comprising an optical relay for ensuring that only part of the holographic recording medium immediately beneath the part of the pattern defined by the mask is illuminated by a reference beam during the recording of the TIR sub-hologram.

13. An apparatus according to any one of claims 9 to 12 further comprising
- a prism having a first and a second face, wherein the substrate is in optical contact with the first prism face of the prism; and
- a translation stage (12) to which the prism is mounted being able to travel in two orthogonal directions.

14. An apparatus according claim 13 wherein the recording means comprise
- a laser source
- a beam splitter and an expanding optics for generating two mutually coherent and collimated light beams, namely an object beam and a reference beam;
- means for directing the object beam (20) to the mask (13) so that it illuminates it at normal incidence;
- means for directing the reference beam through the second prism face so that it illuminates the recording layer (8) at such an angle that it is totally internally reflected from the layer.

15. An apparatus according to any one of claims 9 to 12 further comprising piezo-electric transducers (16) for positioning the mask (13).

## Patentansprüche

1. Verfahren zur Herstellung eines auf totaler interner Reflexion (TIR) basierenden Hologramms zum Vervielfältigen eines Musters von Mikrostrukturen von hoher Qualität über eine grosse Fläche, welches Verfahren folgende Schritte beinhaltet:
a) Bereitstellen eines Substrats (9) von der Grösse des zu vervielfältigenden ganzen Musters, wobei dieses Substrat ein holographisches Aufnahmemedium (8) trägt;
b) Bereitstellen einer Maske (13), welche einen Teil des zu vervielfältigenden Musters definiert;
c) Aufzeichnen eines TIR Sub-Hologramms des durch die Maske definierten Teils des Musters im holographischen Aufnahmemedium (8);
d) Verschieben des Aufnahmemediums (8) oder der Maske (13) relativ zueinander in einer im wesentlichen parallelen Richtung zum holographischen Aufnahmemedium, um einen anderen Teil des holographischen Aufnahmemediums zu präsentieren, um darin ein weitere TIR Sub-Hologramm von derselben oder einer anderen Maske aufzuzeichnen; und
e) Wiederholen der Schritte c) und d), so viele Male wie nötig, um im holographischen Aufnahmemedium eine Reihe von TIR-Sub-Hologrammen aufzuzeichnen und das zu vervielfältigende Muster zu registrieren.

2. Verfahren gemäss Anspruch 1, dadurch gekennzeichnet, dass das Aufzeichnen eines TIR Sub-Hologramms im holographischen Aufnahmemedium die folgenden Schritte umfasst:
- Optisches Kontaktieren des Substrats an einer ersten Prismenseite;
- Erzeugen von zwei gegenseitig kohärenten und kollimierten Strahlen, nämlich eines Objektstrahls und eines Referenzstrahls;
- Ausrichten des Objektstrahls (20) auf die Maske (13), sodass dieser die Maske unter rechtwinkligem Einfallswinkel anstrahlt;
- Ausrichten des Referenzstrahls durch eine zweite Prismenseite, sodass dieser die Aufnahmeschicht (8) unter einem solchen Winkel anstrahlt, dass dieser an der Schicht eine totale interne Reflexion erfährt.

3. Verfahren gemäss Anspruch 1 oder 2, dadurch gekennzeichnet, dass in Schritt (d) das Verschieben in einer oder mehreren von zwei orthogonalen Richtungen erfolgt.

4. Verfahren gemäss einem der Ansprüche 1 bis 3, dadurch gekennzeichnet, dass die Maske im wesentlichen parallel zum holographischen Aufnahmemedium und in einer festen Distanz von dieser gehalten wird.

5. Verfahren gemäss einem der Ansprüche 1 bis 4, dadurch gekennzeichnet, dass nach der Aufzeichnung und der Präsentation eines nicht-belichteten Bereichs der Schicht (8) die Distanz zwischen der Maske (13) und der Schicht (8) gemessen und wieder justiert wird.

6. Verfahren gemäss einem der Ansprüche 1 bis 5, weiter gekennzeichnet dadurch, dass jedes Sub-Hologramm unmittelbar nach seiner Aufzeichnung im holographischen Aufnahmemedium fixiert wird.

7. Verfahren gemäss einem der Ansprüche 1 bis 6, weiter gekennzeichnet dadurch, dass die Anordnung von TIR Sub-Hologrammen im Anschluss an ihre Aufzeichnung im holographischen Aufnahmemedium fixiert wird.

8. Verfahren gemäss einem der Ansprüche 2 bis 7, dadurch gekennzeichnet, dass der Referenzstrahl eine Apertur (23) und ein optisches Relais (24) passiert, um die angestrahlte Apertur (23) auf die Aufnahmeschicht (8) abzubilden.

9. Verfahren gemäss einem der Ansprüche 1 bis 8 weiter gekennzeichnet dadurch, dass die grosse Fläche oder ein wesentlicher Teil von dieser Fläche in einer kleinen Zahl von schrittweisen Repetieroperationen auf ein grosses Substrat kopiert werden.

10. Vorrichtung zur Herstellung einer Anordnung von auf totaler interner Reflexion (TIR) beruhender Hologrammen, um ein Muster von Mikrostrukturen mit hoher Genauigkeit auf eine grosse Fläche vollflächig zu kopieren, mit:
a) einem Substrat (9), welches wenigstens die Grösse des ganzen zu vervielfältigenden Musters aufweist, wobei das Substrat ein holographisches Aufnahmemedium (8) trägt;
b) einer Maske (13) welche einen Teil des zu vervielfältigenden Musters definiert;
c) Mittel, um ein TIR Sub-Hologramm von dem durch die Maske (13) definierten Teil des Musters im holographischen Aufnahmemedium (8) zu registrieren;
d) Mittel (12), um das holographische Aufnahmemedium (8) oder die Maske (13) in einer im wesentlichen zum holographischen Aufnahmemedium (8) parallelen Ebene relativ zueinander zu verschieben, um einen anderen Teil des holographischen Aufnahmemediums (8) zu präsentieren, um darin ein weiteres TIR Sub-Hologramm von dieser oder einer anderen Maske (13) aufzuzeichnen.

11. Vorrichtung gemäss Anspruch 9 dadurch gekennzeichnet, dass die Fläche, welche das Maskenmuster umgibt, undurchsichtig ist, und der Referenzstrahl eine Apertur (23) und ein optisches Relais (24) passiert, um die angestrahlte Apertur (23) auf der Aufnahmeschicht (8) abzubilden.

12. Vorrichtung gemäss Anspruch 9 oder 10, weiter gekennzeichnet durch ein optisches Relais zum Sicherstellen, dass nur ein Teil des unmittelbar unterhalb des durch die Maske definierten Teils des Musters liegenden holographischen Aufnahmemediums durch den Referenzstrahl während der Aufzeichnung des TIR Sub-Hologramms angestrahlt wird.

13. Vorrichtung gemäss einem der Ansprüche 9 bis 12, weiter gekennzeichnet durch
- ein Prisma mit einer ersten und einer zweiten Seite, wobei das Substrat in optischem Kontakt mit der ersten Prismenseite ist; und
- einem Tisch, auf welchen das Prisma montiert ist und welcher sich in zwei orthogonalen Richtungen hin- und herbewegen kann.

14. Vorrichtung gemäss Anspruch 12, dadurch gekennzeichnet, dass die Aufzeichnungsmittel folgendes umfassen:
- eine Laserquelle;
- einen Strahlteiler und eine Expansionsoptik, um zwei gegenseitig kohärente und kollimierte Lichtstrahlen zu erzeugen, nämlich einen Objektstrahl und einen Referenzstrahl;
- Mittel, um den Objektstrahl (20) auf die Maske (13) auszurichten, sodass dieser die Maske unter normalem Einfallswinkel anstrahlt;
- Mittel, um den Referenzstrahl durch die zweite Prismenseite zu leiten, sodass dieser die Aufnahmeschicht (8) unter einem solchen Winkel anstrahlt, dass dieser an der Schicht intern total reflektiert wird.

15. Vorrichtung gemäss einem der Ansprüche 9 bis 12, weiter gekennzeichnet durch piezo-elektrische Umformer (16), um die Maske (13) zu positionieren.

## Revendications

1. Procédé pour fabriquer un groupement d'hologrammes TIR (à réflexion inteme totale) destiné à imprimer un motif constitué de microcaractéristiques de grande qualité sur une surface de grandes dimensions, lequel procédé consiste à :
a) foumir un substrat (9) ayant la taille du motif complet à imprimer, ledit substrat supportant un support d'enregistrement holographique (8) ;
b) fournir un masque (13) définissant une partie du motif à imprimer;
c) enregistrer sur le support d'enregistrement holographique (8) un sous-hologramme TIR de la partie du motif définie par le masque ;
d) déplacer ledit support d'enregistrement holographique (8) ou ledit masque (13) l'un par rapport à l'autre dans une direction pratiquement parallèle au support d'enregistrement holographique (8), de manière à présenter une nouvelle partie du support d'enregistrement holographique afin que puisse être enregistré sur celle-ci un autre sous-hologramme TIR du masque ou d'un autre masque ; et
e) comprenant en outre l'étape consistant à répéter les étapes c) et d) autant de fois que cela est nécessaire, de manière à enregistrer sur le support d'enregistrement holographique un groupement de sous-hologrammes TIR comportant l'enregistrement du motif à imprimer.

2. Procédé selon la revendication 1, dans lequel l'enregistrement d'un sous-hologramme TIR sur le support d'enregistrement holographique comprend les étapes consistant à :
- mettre en contact optiquement le substrat avec une première face d'un prisme ;
- générer deux faisceaux mutuellement cohérents et collimatés, à savoir un faisceau objet et un faisceau de référence ;
- diriger le faisceau objet (20) sur le masque (13) de manière à ce que celui-ci l'éclaire sous une incidence normale;
- diriger le faisceau de référence via une seconde face du prisme, de sorte que celui-ci éclaire la couche d'enregistrement (8) sous un angle tel que celui-ci soit entièrement réfléchi, d'une manière interne, par la couche.

3. Procédé selon la revendication 1 ou 2, dans lequel, au cours de l'étape d), ledit déplacement est effectué dans l'une, ou plus d'une, parmi deux directions orthogonales.

4. Procédé selon l'une quelconque des revendications 1 à 3, dans lequel le masque est maintenu pratiquement parallèle au support d'enregistrement holographique et l'est à une distance fixe de celui-ci.

5. Procédé selon l'une quelconque des revendications 1 à 4, dans lequel la distance entre le masque (13) et la couche (8) est mesurée et réajustée après enregistrement et déplacement dans une région non-exposée de la couche (8).

6. Procédé selon l'une quelconque des revendications 1 à 5, comprenant en outre l'étape consistant à fixer chaque sous-hologramme immédiatement après son enregistrement sur le support d'enregistrement holographique.

7. Procédé selon l'une quelconque des revendications 1 à 6, comprenant en outre l'étape consistant à fixer le groupement de sous-hologrammes TIR après leur enregistrement sur le support d'enregistrement holographique.

8. Procédé selon l'une quelconque des revendications 2 à 7, dans lequel le faisceau de référence passe à travers une ouverture (23) et un relais optique (24) afin de former l'image de l'ouverture éclairée (23) sur la couche d'enregistrement (8).

9. Procédé selon l'une quelconque des revendications 1 à 8, comprenant en outre l'étape consistant à imprimer la surface de grandes dimensions ou une partie importante de cette surface en un petit nombre d'opérations effectuées pas à pas et répétées sur un substrat de grandes dimensions.

10. Dispositif pour fabriquer un groupement d'hologrammes TIR (à réflexion inteme totale) destiné à imprimer en plein-champ un motif constitué de microcaractéristiques de grande précision sur une surface de grandes dimensions, lequel dispositif comporte :
a) un substrat (9) ayant au moins la taille du motif complet à imprimer, ledit substrat supportant un support d'enregistrement holographique (8);
b) un masque (13) définissant une partie du motif à imprimer;
c) des moyens pour enregistrer sur le support d'enregistrement holographique (8) un sous-hologramme TIR de la partie du motif définie par le masque (13); et
d) des moyens (12) pour déplacer ledit support d'enregistrement holographique (8) ou ledit masque (13) l'un par rapport à l'autre dans un plan pratiquement parallèle au support d'enregistrement holographique (8) de manière à présenter une nouvelle partie du support d'enregistrement holographique (8) afin que puisse être enregistré sur celle-ci un autre sous-hologramme TIR du masque (13) ou d'un autre masque.

11. Dispositif selon la revendication 9, dans lequel la surface entourant le motif du masque est opaque et le faisceau de référence passe à travers une ouverture (23) et un relais optique (24) afin de former l'image de l'ouverture éclairée (23) sur la couche d'enregistrement (8).

12. Dispositif selon la revendication 9 ou 10, comprenant en outre un relais optique destiné à assurer que seule une partie du support d'enregistrement holographique, située immédiatement au-dessous de la partie du motif définie par le masque, sera éclairée par un faisceau de référence durant l'enregistrement du sous-hologramme TIR.

13. Dispositif selon l'une quelconque des revendications 9 à 12, comprenant en outre
- un prisme ayant une première et une seconde face, dans lequel le substrat est en contact optique avec la première face du prisme ; et
- une platine de déplacement (12) sur laquelle est monté le prisme, pouvant être déplacée dans deux directions orthogonales.

14. Dispositif selon la revendication 13, dans lequel les moyens d'enregistrement comprennent
- une source laser
- un séparateur de faisceaux et un expanseur optique pour générer deux faisceaux de lumière mutuellement cohérents et collimatés, à savoir un faisceau objet et un faisceau de référence ;
- des moyens pour diriger le faisceau objet (20) sur le masque (13) de sorte que celui-ci l'éclaire sous une incidence normale ;
- des moyens pour diriger le faisceau de référence via la seconde face du prisme de sorte que celui-ci éclaire la couche d'enregistrement (8) sous un angle tel que celui-ci soit totalement réfléchi, d'une manière inteme, par la couche.

15. Dispositif selon l'une quelconque des revendications 9 à 12, comprenant en outre des transducteurs piézo-électriques (16) pour positionner le masque (13).
